# EUROPEAN PATENT APPLICATION

(11) **EP 1 489 127 A1**
(43) Date of publication of application: **22.12.2004**
(21) Application number: 03029145.4
(22) Date of filing: 18.12.2003
(51) Int. Cl.: C08G 73/10, C09J 179/08, H05K 1/03

(54) **Polyimide resin and cast-on-copper laminate**

(30) Priority: 20.06.2003 US 465652
(71) Applicant: Thinflex Corporation, Miaoli30, Taiwan (CN)
(72) Inventor: Huang, Chuan-Yi, Miaoli 350 Taiwan (CN); Hsu, Yen-Huey, Miaoli 350 Taiwan (CN)
(74) Representative: Haft, von Puttkamer, Berngruber, Karakatsanis

(57) **Abstract**

A polyimide polymer made from a dianhydride of 3,3',4,4'-Biphenyltetracarboxylic dianhydride and diamines of p-phenylenediamine and oxydianiline, having similar coefficient of thermal expansion, useful for producing polyimide cast-on-copper laminate, which having an excellent dimensional stability.

## Description

### FIELD OF THE INVENTION

This invention relates to polyimide resin, which is suitable for use in the production of cast-on-copper laminate, and more particularly, the invention relates to polyimide resin having closer coefficient of thermal expansion to copper foil and an improved dimensional stability of polyimide cast-on-copper laminate.

### BACKGROUND OF THE INVENTION

Flexible printed circuit boards have been widely used in consumer applications such as notebook computers, mobile phones, personal digital assistants and digital cameras. As the demand for smaller and lighter consumer electronic products, flexible printed circuit boards moving toward thinner and lighter adhesiveless polyimide cast-on-copper laminate.

Generally, an adhesiveless polyimide cast-on-copper laminate was producing by coating polyamic acid precursor on the surface of copper foil, and then, treating with high temperature to imidize the polyamic acid to polyimide film, wherein the polyamic acid precursor was preparing by reacting dianhydride compounds and diamine compounds in a polar aprotic solvent system. There is no adhesive layer between the polyimide film and the copper foil.

Accordingly, a continuous process for manufacturing flexible printed circuits may include many transfer carriers and the flexible laminate will be to pass many narrow opener or slit. Therefore, the flatness should be the most concerned requirements to process the flexible laminate and should not be curly, either before or after etching. Unfortunately, an adhesiveless polyimide cast-on-copper laminate shown curly easily due to absence of adhesive layer and have relative thinner thickness. Because of the present difference of coefficient of thermal expansion between polyimide film and copper foil there will be yielded a strain on the laminate, particular on the laminate after etching process. Furthermore, the strain will also influence the dimensional stability of said polyimide cast-on-copper laminate.

The present invention provides a polyimide resin useful to produce a polyimide cast-on-copper laminate, wherein said polyimide resin having a coefficient of thermal expansion very close to copper foil. Consequently, the polyimide cast-on-copper laminate has an excellent dimensional stability and a good flatness. The present invention also discloses to change the proportions of p-phenylenediamine(PPDA) and oxydianiline(ODA) may change the coefficient of thermal expansion of the polyimide resin. In addition, the present invention also uses inorganic filler to improve the tolerance to difference of coefficient of thermal expansion between polyimide film and copper foil.

### SUMMARY OF THE INVENTION

A primary objective of the present invention is to provide a polyimide resin, which was used for preparing a polyimide cast-on-copper laminate. The polyimide resin made from thermal imidizing a polyamic acid precursor, which obtained by reacting aromatic tetracarboxylic dianhydrides and aromatic diamines in a polar aprotic solvent. The polyimide resin has similar CTE to copper foil and the resulted polyimide cast-on-copper laminate will exist a better dimensional stability

Another object of the present invention is to provide a polyimide resin, wherein the polyimide resin having polyamic acid precursor solution contained adequate inorganic filler. The inorganic filler in polyimide cast-on-copper laminate will improved the tolerance to difference of CTE between polyimide film and copper foil.

Another object of the present invention is to provide a polyimide resin, which was especially useful to prepare an adhesiveless polyimide laminate, which the polyimide resin coated directly on the copper foil surface without any adhesive layer, such as epoxy or acrylic adhesive. Thus, a more thinner flexible printed circuit board can be producing.

Another object of the present invention is to provide a polyimide resin, which was useful to prepare a polyimide cast-on-copper laminate having higher peel strength. This polyimide laminate can improve the reliability of the flexible printed circuit products.

Another object of the present invention is to provide a polyimide cast-on-copper laminate, which having an excellent dimensional stability. A flexible printed circuit using this polyimide cast-on-copper laminate show a good flatness and will be not curly even after etching process, so can meet requirements on the producing of flexible printed circuits.

### DETAILED DESCRIPTION OF THE INVENTION

Regarding the adhesiveless polyimide cast-on-copper laminate, it has been found that the dimensional stability of the laminate will be related to the coefficient of thermal expansion (CTE) of the polyimide resin. In case a large differential of the CTE exists between the polyimide resin and copper foil, a tension will occur in the polyimide cast-on-copper laminate. The tension will make the laminate curly and influence the dimensional stability of the laminate. Therefore, it is desirable to reduce the differential of the CTE exists between the polyimide resin and copper foil and to improve the dimensional stability of the laminate.

In this invention, a thermal resisting polyimide resin made from thermal imidizing a polyamic acid precursor, which obtained by reacting aromatic tetracarboxylic dianhydrides and aromatic diamines in a polar aprotic solvent. The polyamic acid precursor solution comprises two aromatic diamine compounds in various molar ratios and adequate amount of inorganic filler. In the present invention shown, adjusting the molar ratios of two aromatic diamine compounds, the polyimide resin may be obtained a CTE from 10 to 30 ppm/°C and the resulted polyimide cast-on-copper laminate may exist a better dimensional stability.

It has been found in this invention that, if decreased the difference of CTE between polyimide resin and copper foil, there were many dianhydride compounds and diamine compounds in adequate proportion can be used to prepare a polyimide resin for producing the flexible printed circuit boards. However, an adhesiveless polyimide laminate does not have any adhesive layer, the polyimide film is directly coated on the surface of copper foil. Therefore, the polyimide resin used for preparing adhesiveless polyimide laminates should be existed a good adhesion to the surface of copper foil.

To prepare the polyimide resin for producing polyimide laminate, many dianhydrides and diamines in various compositions may be used, preferably dianhydrides including 3,3',4,4'-Biphenyltetracarboxylic dianhydride(BPDA), Pyromellitic dianhydride and Benzophenonetetracarboxylic dianhydride; preferably diamines including p-phenylenediamine(PPDA), oxydianiline(ODA), N,N'-diphenylmethylenediamine and diaminobenzophenone. In this invention, more preferably dianhydride is BPDA and more preferably diamines including PPDA and ODA.

A polyimide resin, comprising BPDA as dianhydride compound and PPDA and ODA as diamine compounds, have an excellent adhesion to the surface of copper foil and useful to prepare an adhesiveless polyimide cast-on-copper laminate. To apply single dianhydride of BPDA as the dianhydride compound, instead of multi-dianhydride compounds, may simplify the polyamic acid reaction and the production process. To adjust the proportion of the mixture of PPDA and ODA, may vary the CTE of the resulted polyimide resin. Because of the polyimide resin contained both PPDA and ODA compounds have a good thermal resistance, chemical resistance as well as a good adhesion to the surface of copper foil, therefore, the molar ratios of the PPDA and ODA may be located in wide ranges. In case of some applications of flexible printed circuits, the molar ratios of the PPDA and ODA may be applied from 0.1 to 10.0, but in some severe applications, the molar ratios of the PPDA and ODA should be applied from 1.0 to 4.0, wherein the CTE of resulted polyimide resin were about 15 to 27 ppm/°C, very close to the CTE of copper foil.

As mentioned above, the CTE of the polyimide resin is closer to the copper foil the laminate will have lesser the strain. Indeed, to approach this goal, it should be sacrificed some useful properties of polyimide resin, for instance, selections of the dianhydride compounds and the diamine compounds will be limited to obtain a polyimide resin which CTE is close to the copper foil. Practically, as many large scale production, the CTE of polyimide resins always locate in a certain ranges, and a difference of CTE between polyimide resin and copper foil may be in a certain ranges. Thus, one approach for solving this problem is improving the tolerance to difference of CTE between polyimide film and copper foil.

Regarding aforementioned problems of a differential of CTE of polyimide resin and copper foil, this invention try to improve the tolerance to difference of CTE between polyimide film and copper foil by adding inorganic filler chosen from talc, mica, silica, calcium carbonate or mixtures thereof. It has been found that the polyamic acid precursor should be added sufficient inorganic filler so that the resulted polyimide cast-on-copper laminate has enough tolerance to difference of CTE between polyimide film and copper foil, and these results may be proved by the measurements of dimensional stability of final products of flexible printed circuit boards. In the example 2, with reference to table 1, the molar ratio of PPDA/ODA is 0.8 : 1.0, the polyamic acid solution contains 20% of total weight of reactants(i.e. dianhydrides and diamines). While the polyimide resin having 30ppm/°C of CTE, which is higher than 17ppm/°C of copper foil, the resulted polyimide cast-on-copper laminate has 0.14% of average value of dimensional stability, which meets the requirements on IPC-FC-241/11 Class 3. Indeed, as indicated above, certain compositions of polyamic acid solution, even the polyimide resin without inorganic filler has much higher CTE than copper foil and the resulted polyimide cast-on-copper laminate has higher value of dimensional stability, but the polyimide resin contained some of inorganic filler, the resulted polyimide cast-on-copper laminate may meet the requirements on flexible printed circuits industry.

The addition of inorganic fillers in the polyamic acid precursor may influence many characters of the resulted polyimide resin as well as the polyimide cast-on-copper laminate. In this invention, the polyamic acid precursor was added sufficient inorganic filler, preferably talc or mica powder, and the amount of inorganic filler should be at least 10% of total weight of reactants.

In this invention, the polyamic acid solution, comprising a dianhydride of 3,3',4,4'-Biphenyltetracarboxylic dianhydride and diamines of p-phenylenediamine and oxydianiline, was coating on the surface of copper foil, and then, high temperature imidizing to form a thermal resistant polyimide film and obtain a polyimide cast-on-copper laminate. The polyimide cast-on-copper laminates, useful to producing flexible printed circuit boards, exhibit a good adhesion between polyimide film and copper foil. The measurements of peel strength meet the requirement on IPC-TM-650, method 2.2.9 and IPC-FC-241/11 Class 3.

In this invention, the polyamic acid solution comprising a dianhydride of 3,3',4,4'-Biphenyltetracarboxylic dianhydride and diamines of p-phenylenediamine and oxydianiline, and, in addition, talc or mica powder in amount of at least 10% of total weight of reactants was adding to the polyamic acid solution. The polyamic acid solution was coating on the surface of copper foil, and then, high temperature imidizing to form a thermal resistant polyimide film and obtain a polyimide cast-on-copper laminate. The polyimide cast-on-copper laminates, useful to producing flexible printed circuit boards, having an excellent dimensional stability meet the requirement on IPC-TM-650, method 2.2.4 and IPC-FC-241/11 Class 3. There is a severe requirement on IPC-FC-241/11 Class 3, the average value of dimensional stability must lesser than 0.2%.

This invention will now be described with examples, but this invention is not limited to these examples.

### Example 1

To a reaction vessel was added 168 ml of N-methylpyrrolidone(NMP) and 6.4 g of mica powder, then stirring. To the stirring solution, 3.39 g (31.4 mmol ) of p-phenylenediamine(PPDA) and 7.85 g (39.3 mmol) of oxydianiline(ODA) were added, and stirring by 60 rpm at 35°C water bath and stirred until homogeneous diamines solution was formed. To the stirring diamines solution, 20.76 g (70.6 mmol) of 3,3',4,4'-Biphenyltetracarboxylic dianhydride(BPDA) was added gradually, and the mixture was stirring and reacting for 3 hrs, to form a polyamic acid solution of 18.6% by weight solids. The polyamic acid solution removed from the reaction vessel and then coated on the surface of copper foil, then thermal treatment under 80°C-10min, 120°C-10min, 150°C-10min, 210°C -10min and 350°C-10min. The treated polyamic acid was imidized and formed a polyimide film on the copper foil, and finally, a polyimide cast-on-copper laminate was obtained.

Because dianhydrides may be reacted with polar aprotic solvents, solids of PPDA and ODA were added into the solvent firstly, and then the BPDA was added gradually into diamines solution. Generally, the reactants will be reacted to form a polyamic acid solution of 18.6% by weight solid, and the polyamic acid solution contained mica powder of 20% of total weight of dianhydride and diamines. Furthermore, in the multiple steps of thermal treatments, the solvent system of polyamic acid will be removed on early stage, and then the polyamic acid will be imidized to polyimide under high temperature and formed a polyimide film on the surface of copper foil.

In this invention, the concerned characters of resulting polyimide resin will be depended upon the variety of molar ratio of PPDA to ODA. For instance, to change the molar ratio of PPDA to ODA will result a different value of the coefficient of thermal expansion of the polyimide resin. In this example, the molar ratio of dianhydrides to diamines of reactants of the polyamic acid solution was 1 : 1 and the molar ratio of p-phenylenediamine (PPDA) to oxydianiline (ODA) of the diamines was 0.8 : 1.0. The polyamic acid solution used the 3,3',4,4'-Biphenyltetracarboxylic dianhydride (BPDA) as only dianhydride component.

The coefficient of thermal expansion of the polyimide resin was, measured by a thermal mechanical analysis (TMA), about 30ppm/°C. The polyimide cast-on-copper laminate having a peel strength of 1.82 kg/cm as measured by IPC-TM-650, method 2.2.9 and having dimensional stability of 0.14% as measured by IPC-TM-650, method 2.2.4. In addition, this polyimide cast-on-copper laminate having a good flatness and no curly edge occurred after etching test.

### Examples 2 through 7

In the Examples 2 through 7, the reactants and the procedure of Example 1 were repeated except that the relative proportions of the PPDA and ODA were varied. The molar ratios of PPDA to ODA were from about 1 : 1 to about 6:1. The different proportions of the PPDA to ODA will result a variety of the coefficients of thermal expansion of the polyimide resin, and thus, will result a variety of the dimensional stability of polyimide cast-on-copper laminates producing thereof. The variety of the dimensional stability will change the adhesion between the polyimide film and copper foil and further vary the value of peel strength of the polyimide cast-on-copper laminates

### Comparative Example A and B

In Comparative Example A and B, the procedure of Example 1 was repeated except that the composition of diamines of the polyamic acid solution. In Comparative Example A, the polyamic acid solution comprising 3,3',4,4'-Biphenyltetracarboxylic dianhydride (BPDA) as dianhydride component and oxydianiline(ODA) as diamine component. In Comparative Example B, the polyamic acid solution comprising BPDA as dianhydride component and p-phenylenediamine(PPDA) as damine component.

Table 1 shows the compositions of polyamic acid solutions of Example 1 through 7 and Comparative Example A and B. Table 2 shows typical mechanical properties along with applicable test methods.

**Table 1**

| Ex. | NMP (gram) | BPDA (gram) (mmol) | PPDA (gram) (mmol) | ODA (gram) (mmol) | PPDA/ODA | Mica (gram) | Solid Content (%) |
|---|---|---|---|---|---|---|---|
| 1 | 168 | 20.76 | 3.39 | 7.85 | 0.8 | 6.4 | 18.6 |
| | | (70.6) | (31.4) | (39.3) | | | |
| 2 | 168 | 21.00 | 3.86 | 7.15 | 1.0 | 6.4 | 18.6 |
| | | (71.4) | (35.7) | (35.8) | | | |
| 3 | 168 | 21.74 | 5.33 | 4.93 | 2.0 | 6.4 | 18.6 |
| | | (73.9) | (49.4) | (24.7) | | | |
| 4 | 168 | 22.13 | 6.10 | 3.77 | 3.0 | 6.4 | 18.6 |
| | | (75.3) | (56.5) | (18.9) | | | |
| 5 | 168 | 22.38 | 6.58 | 3.05 | 4.0 | 6.4 | 18.6 |
| | | (76.1) . | (61.0) | (15.3) | | | |
| 6 | 168 | 22.54 | 6.90 | 2.56 | 5.0 | 6.4 | 18.6 |
| | | (76.7) | (63.9) | (12.8) | | | |
| 7 | 168 | 22.66 | 7.13 | 2.20 | 6.0 | 6.4 | 18.6 |
| | | (77.1) | (66.0) | (11.0) | | | |
| A | 168 | 19.04 | -- | 12.96 | -- | 6.4 | 18.6 |
| | | (64.8) | | (64.8) | | | |
| B | 168 | 23.40 | 8.60 | -- | -- | 6.4 | 18.6 |
| | | (80.0) | (80.0) | | | | |

**Table 2**

| Ex. | PPDA/ODA | CTE (ppm/°C) | Dimensional Stability (%) | Peel Strength (kg/cm) |
|---|---|---|---|---|
| 1 | 0.8 : 1 | 30 | 0.140 | 1.820 |
| 2 | 1 : 1 | 27 | 0.085 | 1.829 |
| 3 | 2 : 1 | 26 | 0.031 | 1.683 |
| 4 | 3 : 1 | 19 | 0.018 | 1.232 |
| 5 | 4 : 1 | 15 | 0.027 | 1.087 |
| 6 | 5 : 1 | 13 | 0.110 | 0.802 |
| 7 | 6 : 1 | 10 | 0.161 | 0.685 |
| A | -- | 44 | 0.326 | 2.507 |
| B | -- | 9 | 0.239 | 0.705 |
| Dimensional Stability: IPC-TM-650, method 2.2.4 Peel Strength: IPC-TM-650, method 2.2.9 | | | | |

In order of Example 1 to Example 7, the molar ratios of PPDA to ODA were from 0.8 : 1 to 6 : 1, the coefficients of thermal expansion were decreasing as the portions of PPDA were increasing. This result may be related to the molecular structure of PPDA and ODA compounds. Unlike ODA, PPDA molecule lacks an ether-oxygen between two benzyl structure and shows less flexible. Consequently, the polyimide resin containing more PPDA compound has a relative low coefficient of thermal expansion. As is commonly known, the polyimide resin contained ODA compound will exhibit an excellent adhesion to copper foil. The peel strength of polyimide cast-on-copper laminate will be improved as increasing the portion of ODA of polyimide resin. Contrarily, the peel strength of polyimide cast-on-copper laminate will be decreasing as increasing the portion of PPDA of polyimide resin. The same result was also shown in the Comparative Example A and B.

According to examples 1 through 3, the polyimide resin having the average value of coefficient of thermal expansion(CTE) between 26.1 - 30 ppm/°C. Although they exist certain differential of CTE between polyimide resin and copper foil, these results shown the addition of mica powder, which was added in the polyamic acid solution, may improve the tolerance of the differential of CTE in the polyimide cast-on-copper laminate. It is can be proved by said polyimide cast-on-copper laminates still have excellent dimensional stability, which are less than 0.2 %. In examples 5 through 7, the relative lower peel strength may be explained as the polyamic acid solution contains more portions of the PPDA. According to, all of examples 1 through 7 will meet the requirement on the flexible printed circuits industry. However, examples 2 through 5 would be the better for combining requirements on the peel strength and the dimensional stability.

## Claims

1. A polyimide resin, which useful to produce a polyimide cast-on-copper laminate, made from thermal imidizing polyamic acid precursor, which obtained by reacting aromatic tetracarboxylic dianhydrides and aromatic diamines in a polar aprotic solvent, wherein the polyamic acid solution comprising inorganic filler selected from talc and mica powders at least 10% based on total amount of reactants, wherein the polyimide resin having coefficient of thermal expansion in the range of from 10 to 30 ppm/°C.

2. A polyimide resin according to claim 1, wherein the aromatic tetracarboxylic dianhydrides are selected from the group comprising 3,3',4,4'-biphenyltetracarboxylic dianhydride, pyromellitic dianhydride and benzophenonetetracarboxylic dianhydride , and mixtures thereof, and wherein the aromatic diamines are selected from the group comprising p-phenylenediamine, oxydianiline, N,N'-diphenylmethylenediamine and diaminobenzophenone, and mixtures thereof.

3. A polyimide resin according to claim 2, wherein the aromatic tetracarboxylic dianhydride is 3,3',4,4'-biphenyltetracarboxylic dianhydride, and wherein the aromatic diamines are p-phenylenediamine and oxydianiline and the mole ratio of p-phenylenediamine to oxydianiline is in the range of from 0.1 to 10.0.

4. A polyimide resin according to claim 3, wherein the mole ratio of the p-phenylenediamine to oxydianiline is in the range of from 1.0 to 4.0.

5. A polyimide cast-on-copper laminate, which useful to produce flexible printed circuit boards, producing by casting the polyamic acid solution of claim 1 on the surface of copper foil and thermal imidizing the polyamic acid to forrm a thermal resisting polyimide on the surface of copper foil.

6. A polyimide cast-on-copper laminate, which useful to produce flexible printed circuit boards, producing by casting the polyamic acid solution of claim 1 on the surface of copper foil and thermal imidizing the polyamic acid to forrm a thermal resisting polyimide film on the surface of copper foil, wherein the polyimide cast-on-copper laminate having a measured value of lesser than 0.20% of dimensional stability and meet reqquirement on 1PC-TM-650, method 2.2.4.
